# EUROPEAN PATENT SPECIFICATION

(11) **EP 3 945 760 B1**
(45) Date of publication and mention of the grant of the patent: **09.04.2025**
(21) Application number: 20188005.1
(22) Date of filing: 27.07.2020
(51) Int. Cl.: H05K 7/20

(54) **NEGATIVE RELATIVE PRESSURE COOLING SYSTEMS**
KÜHLSYSTEME MIT NEGATIVEM RELATIVDRUCK
SYSTÈMES DE REFROIDISSEMENT À PRESSION RELATIVE NÉGATIVE

(43) Date of publication of application: 02.02.2022
(73) Proprietor: GE Energy Power Conversion Technology Ltd, Rugby, Warwickshire CV21 1BD (GB)
(72) Inventor: Yabiku, Renato, Rugby, Warwickshire CV21 1BU (GB); Dickens, Kevin, Rugby, Warwickshire CV21 1BU (GB)
(74) Representative: Serjeants LLP

(56) References cited:
- EP-A1- 2 350 767
- EP-A1- 3 079 239
- WO-A1-01/55662
- CA-A- 1 185 654
- DE-A1- 102006 033 030
- DE-A1- 102012 006 518
- GB-A- 2 355 857
- US-A- 4 967 832

## Description

### Technical Field

The present invention relates to negative relative pressure cooling systems, and in particular to such cooling systems for cooling an electrical machine (e.g., a motor or generator).

### Background Art

It is known to produce laminated stators for electrical machines by pressing stacks of annular laminations together. The laminations are typically formed from sheets of electrical grade steel which are usually provided with insulating coatings. Each annular lamination may be formed of a single member or may itself be of segmental construction with the segments abutted against each other e.g., at generally radially extending edges.

The laminations can define axially extending teeth that define therebetween axially extending slots for receiving the conductors of a stator winding. The teeth are circumferentially spaced around the stator surface and carry the magnetic flux that links from the stator to the rotor across the airgap. The conductors are electrically insulated from the teeth.

One of the problems faced by designers of electrical machines is the heat that is created as a result of the various losses, e.g., resistive losses in the stator winding, eddy current losses in the laminations etc. The problem of heat can be particularly acute when trying to design an electrical machine with high power density (i.e., power generated per unit volume). The maximum power output of an electrical machine, for a given amount of conductive material (e.g., copper for the stator winding conductors and iron for the magnetic circuit) is limited by the efficiency of the cooling because, if heat is not removed efficiently, the temperature of the electrical machine will increase to a point that can cause the insulation material or some other part of the machine to fail.

Electrical machines can be cooled in a variety of different ways, e.g., direct liquid or air cooling, cooling by conduction to the laminations which are in turn cooled by direct cooling or an external water jacket. However, all of these known ways of cooling suffer from some disadvantages in terms of their available power density, thermal transfer efficiency, mechanical complexity, or noise. It is known to pass cooling liquid through axially extending cooling passageways in the stator core or even in the stator teeth. The axially extending cooling passageways can be defined by openings in the individual laminations that define axially extending voids when the laminations are stacked together. It is known to position a tube within each void to contain the cooling liquid and prevent any risk of the cooling liquid leaking between the laminations. But improved cooling can be obtained if the tube is omitted such that the cooling passageways are defined by the axially extending voids and the cooling liquid is in direct contact with the lamination stack. When the stacked laminations are compressed and subjected to appropriate treatment including vacuum pressure impregnation (VPI) and curing, each cooling passageway is preferably made fluid tight. However, it has not always been possible to completely eliminate the risk that the cooling liquid will leak out between adjacent laminations.

EP 3079239 discloses cooling of an electrical machine having a stator and a cooling passageway formed in or adjacent the stator.

It is also known to pass cooling liquid through cooling passageways in industrial transformers, and in particular through the laminated transformer core - see GB 2355857, for example.

It is also known to cool electronic equipment using a negative relative pressure cooling system. For example, EP 2350767 uses a negative relative pressure cooling system with a pressure of 60-80 kPa to cool a computer system and computer components.

Similar cooling systems for cooling electrical apparatus, integrated circuit (IC) chips, computer racks etc. are described in CA 1185654, US 4967832, DE 102006033030, and WO 01/55662.

### Summary of the invention

The present invention provides a combination of an electrical machine (e.g., a motor or generator) comprising a stator and a cooling passageway formed in or adjacent to to the stator and adapted to cool the stator, and a negative relative pressure cooling system connected to the cooling passageway and adapted to move cooling liquid through the cooling passageway at a pressure less than the ambient atmospheric pressure (e.g., less than about 100kPa).

The cooling system can comprise a source of cooling liquid.

The cooling passageway can comprise an inlet (i.e., a first or upstream end of the cooling passage) connected to the source of cooling liquid and an outlet (i.e., a second or downstream end of the cooling passage) for discharging the cooling liquid and any entrained air that enters the cooling passageway. As will be explained in more detail below, if the cooling passageway does not contain any leaks, no air will be entrained in the cooling liquid. But in the event that there is a leak in the cooling passageway, because the cooling liquid is at a pressure that is less than ambient atmospheric pressure, air is effectively drawn into the cooling passageway. Put another way, instead of cooling liquid coming out of the hole or gap in the cooling passageway that would normally constitute the leak, air goes in to the cooling passageway and becomes entrained in the cooling liquid. It will be readily understood that this provides a significant benefit because of the serious damage that can be caused if the cooling liquid leaks out of the cooling passageway and into the electrical machine.

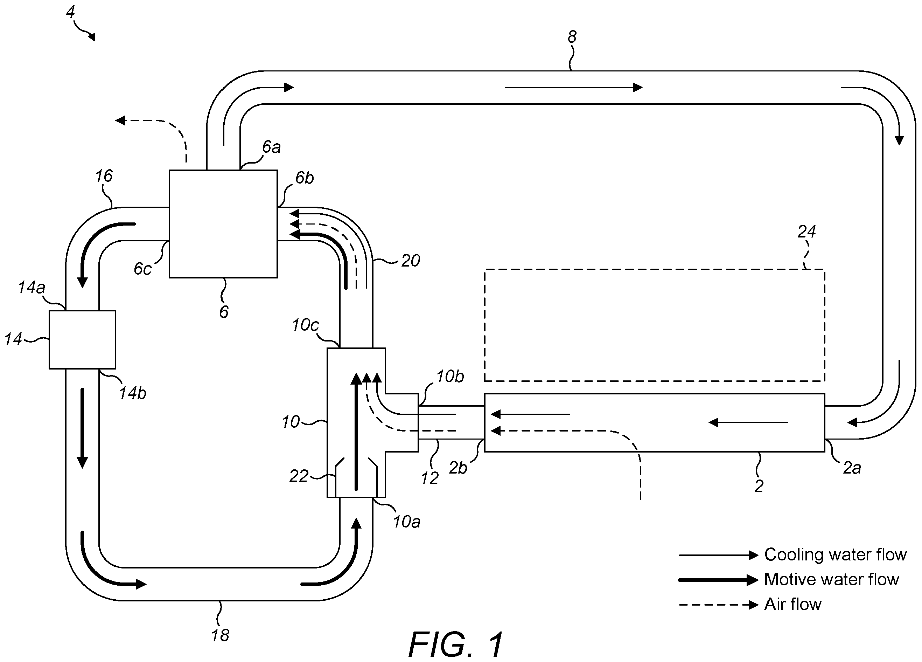

The cooling system can further comprise a liquid-actuated aspirator. In a typical liquid-actuated aspirator, a motive liquid flows through a tube that narrows and then expands in cross-sectional area along the flow direction. When the tube narrows, the pressure of the motive liquid decreases, and the velocity of the motive liquid must increase. Where the tube narrows, a vacuum is created as a result of the Venturi effect, which vacuum can be used to draw (or "pull") the cooling liquid from the source towards the liquid-actuated aspirator through the cooling passageway. The liquid-actuated aspirator can include a first (or motive) inlet connected to a source of motive liquid, a second (or suction) inlet connected to the outlet of the cooling passageway for receiving the cooling liquid and any entrained air, and an outlet for discharging the motive liquid, the cooling liquid and any entrained air. The first inlet and the outlet are normally aligned along an axis of the liquid-actuated aspirator. The axis of the second inlet is normally aligned substantially perpendicular to the axis of the liquid-actuated aspirator. The second inlet is also normally aligned with the part of the liquid-actuated aspirator where the tube narrows and then expands (see Figure 1). The flow of the motive liquid through the liquid-actuated aspirator, from the first inlet to the outlet, produces a vacuum that draws the cooling liquid and any entrained air towards the second inlet where it mixes with the motive liquid. The motive liquid, cooling liquid and any entrained air is then discharged from the outlet.

The present invention can be provided as a closed-loop system that comprises the cooling passageway and the components of the cooling system that are connected together by suitable tubing or pipework. The cooling system is also connected to the cooling passageway by suitable tubing or pipework. In particular, where respective inlets and outlets are described herein as being connected, it will be understood that this does not mean that they must be directly connected, but that they will normally be indirectly connected by means of suitable tubing or pipework. In such a closed-loop system, the source of the cooling liquid can be a vent tank. The vent tank can comprise a first outlet connected to the inlet of the cooling passageway, and an inlet connected to the outlet of the liquid-actuated aspirator for receiving the motive liquid, the cooling liquid, and any entrained air. The vent tank can also be the source of the motive liquid. In other words, the same liquid can be used as both the motive liquid and the cooling liquid in the closed-loop system. After being discharged from the outlet of the liquid-actuated aspirator, the mixed motive liquid and the cooling liquid can be returned to the vent tank. The vent tank is adapted to vent or remove any entrained air.

The vent tank can be an open tank which allows any entrained air to be vented naturally to the environment, or any entrained air can be actively removed by a suitable removal process or removal equipment.

The vent tank can further comprise a second outlet. The cooling system can further comprise a pump connected to the second outlet of the vent tank and to the first inlet of the liquid-actuated aspirator. Operating the pump will therefore supply motive liquid from the vent tank to the first inlet of the liquid-actuated aspirator. The strength of the vacuum created within the liquid-actuated aspirator typically depends on the flow rate of the motive liquid through the aspirator. Pump operation can therefore be used to control the vacuum that is created within the liquid-actuated aspirator and consequently the flow of cooling liquid from the vent tank to the second inlet of the liquid-actuated aspirator through the cooling passageway.

The closed-loop system can be considered in terms of:
- a closed-loop cooling circuit that comprises the vent tank as a source of cooling liquid, the cooling passageway and the liquid-actuated aspirator, and where the cooling liquid is circulated around the closed-loop cooling circuit by the vacuum created by the liquid-actuated aspirator, and
- a closed-loop motive circuit that comprises the vent tank as a source of motive liquid, the pump and the liquid-actuated aspirator, and where the motive liquid is circulated around the closed-loop motive circuit by the operation of the pump.

Although normally less desirable, the present invention can be provided as an open-loop system where the cooling liquid is drawn (or "pulled") from a source of cooling liquid and the motive liquid is provided to the liquid-actuated aspirator from the same or a separate source of motive liquid (e.g., by a pump) and where the mixed cooling liquid, motive liquid and any entrained air is simply discharged from the outlet of the liquid-actuated aspirator. Such an open-loop system might be possible, for example, if there is a reservoir, lake, river or the like from which a suitable liquid (e.g., water) can be drawn through the cooling passageway to provide cooling and from which it can be pumped to the liquid-actuated aspirator as the motive liquid. The liquid discharged from the outlet of the liquid-actuated aspirator can be disposed of in a safe manner rather than being returned to the reservoir, lake, river or the like.

The cooling system can further comprise filtration systems for filtering the cooling liquid and/or the motive liquid.

The electrical machine can comprise a plurality of cooling passageways, e.g., where the inlets and outlets of the cooling passageways are connected together by inlet and outlet manifolds, respectively. In this case, the negative relative pressure cooling system will be connected to the inlet and outlet manifolds. Other arrangements are possible. For example, where a plurality of cooling passageways are connected in series and are used to cool the same or different parts of the electrical machine.

The cooling passageway(s) can be formed in or adjacent to the stator and can be adapted to cool the stator. In one preferred arrangement, each cooling passageway can be an axially extending cooling passageway through the stator core or a stator tooth, for example. Each cooling passageway can extend along the full axial length of the stator or along just part of the stator. Preventing the leakage of cooling liquid can be particularly advantageous if the stator is a laminated stator - see above - and each cooling passageway is defined by an axially extending void in the lamination stack such that the cooling liquid is in direct contact with the lamination stack. When the stacked laminations are compressed and subjected to appropriate treatment including, for example, vacuum pressure impregnation (VPI) and curing, each cooling passageway is preferably made fluid tight. Any inlet and outlet manifolds may be also subjected to the VPI and curing process and provide a fluid tight seal around the end of each cooling passageway. But if there is a small leak between individual laminations or within a manifold, for example, air will be drawn into the axially extending void because the pressure is less than ambient atmospheric pressure and will be entrained in the cooling liquid. The cooling liquid will not leak out of the cooling passageway and into the laminated stator.

The present invention further provides a method of cooling an electrical machine (e.g., a motor or generator) comprising a stator and a cooling passageway formed in or adjacent to the stator and adapted to cool the stator, the method comprising moving cooling liquid through the cooling passageway at a pressure less than the ambient atmospheric pressure.

The step of moving cooling liquid through the cooling passageway can comprise drawing cooling liquid from a source through the cooling passageway and discharging the cooling liquid and any entrained air that enters the cooling passageway from the cooling passageway. The cooling liquid is preferably drawn from the source using a vacuum created by a liquid-actuated aspirator. The source of the cooling liquid can be a vent tank which is adapted to vent any air that is entrained in the cooling liquid.

Any suitable cooling liquid can be used, including water.

### Drawings

Figure 1 is a schematic drawing showing a negative relative pressure cooling system connected to a cooling passageway according to the present invention; and
Figure 2 is an axial cross section drawing of an electrical machine comprising the cooling passageway.

Referring to Figure 1, a cooling passageway 2 is adapted to cool part of an electrical machine 24. A negative relative pressure cooling system 4 is connected to the cooling passageway 2 as described in more detail below.

The cooling system 4 includes a vent tank 6 that contains water. The vent tank 6 includes an inlet 6a, a first outlet 6b and a second outlet 6c.

The cooling passageway 2 includes an inlet 2a that is connected to the first outlet 6b of the vent tank 6 by suitable tubing or pipework 8.

The cooling system 4 includes an aspirator 10. The aspirator 10 includes a first inlet 10a, a second inlet 10b and an outlet 10c.

The cooling passageway 2 includes an outlet 2b that is connected to the second inlet 10b of the aspirator 10 by suitable tubing or pipework 12.

The cooling system 4 includes a pump 14. The pump 14 includes an inlet 14a and an outlet 14b. The inlet 14a of the pump 14 is connected to the second outlet 6c of the vent tank 4 by suitable tubing or pipework 16. The outlet 14b of the pump 14 is connected to the first inlet 10a of the aspirator 10 by suitable tubing or pipework 18.

The outlet 10c of the aspirator 10 is connected to the inlet 6a of the vent tank 6 by suitable tubing or pipework 20.

To provide cooling, the pump 14 is operated to pump water from the vent tank 6 to the first inlet 10a of the aspirator 10. The first inlet 10a and the outlet 10c of the aspirator 10 are aligned along an axis of the aspirator. As the water - acting as a motive liquid - flows between the first inlet 10a and the outlet 10c it passes through a tube 22 which narrows and then expands in cross-sectional area along the flow direction. When the tube narrows, the pressure of the water decreases, and the velocity of the water must increase. Where the tube narrows, a vacuum is created as a result of the Venturi effect, which vacuum can be used to draw (or "pull") water from the vent tank 6 towards the aspirator 10 through the cooling passageway 2. The second inlet 10b of the aspirator 10 is aligned substantially perpendicular to the axis of the aspirator and is positioned where the tube 22 narrows and then expands.

In Figure 1, the water that is pumped around a closed-loop motive circuit is indicated by bold arrows. The closed-loop motive circuit includes the vent tank 6, which acts as a source of motive water, the pump 14 and the aspirator 10. The water that is drawn through a closed-loop cooling circuit by the aspirator 10 is indicated by non-bold arrows. The closed-loop cooling circuit includes the vent tank 6, which acts as a source of cooling water, the cooling passageway 2 and the aspirator 10. As the water is circulated around the closed-loop cooling circuit, heat is transferred to it from the electrical machine 24 to provide cooling.

Within the aspirator 10, the motive water and the cooling water are mixed, discharged from the outlet 10c and returned to the vent tank 6.

The cooling water is drawn (or "pulled") through the cooling passageway 2 by the vacuum created within the aspirator 10 by the motive water flowing through the tube 22. The cooling water in the closed-loop cooling circuit is therefore at a pressure that is less than the ambient atmospheric pressure (e.g., less than about 100kPa). If the cooling passageway 2 does not contain any leaks, no air will be entrained in the cooling water. But in the event that there is a leak in the cooling passageway 2, because the cooling water is at a pressure that is less than ambient atmospheric pressure, air is effectively drawn into the cooling passageway 2. In Figure 1, the dashed arrows indicate air entering the cooling passageway 2 and then becoming entrained in the cooling water. The leak could be the result of a small gap between two individual stator laminations, for example. Any entrained air is subsequently vented by the vent tank 6 as shown.

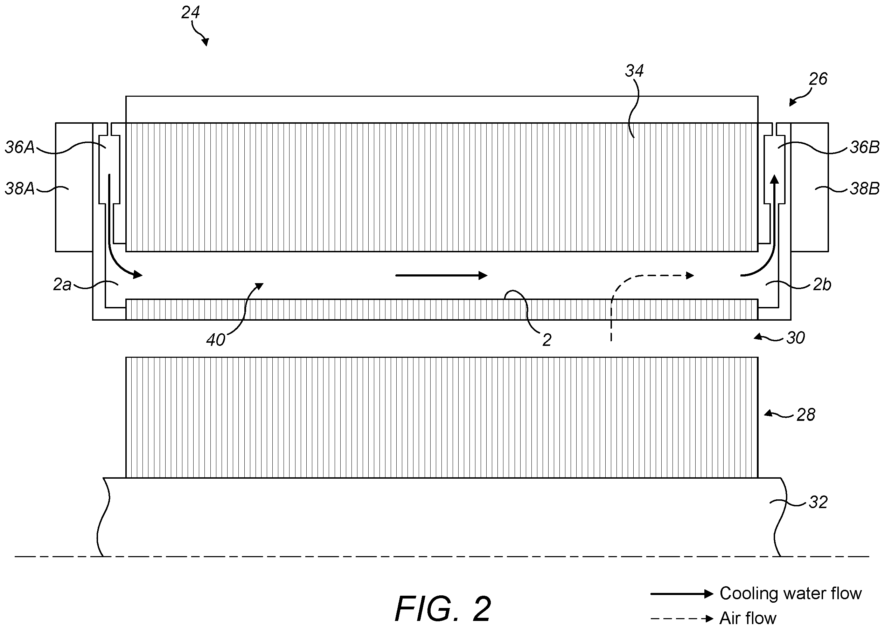

With reference to Figure 2, an electrical machine 24 includes a stator 26 and a rotor 28 separated by an airgap 30. The rotor 28 is mounted on a shaft 32.

The stator 26 includes a stator core 34, a first manifold 36A, a second manifold 36B, a first compression plate 38A and a second compression plate 38B.

The stator core 34 is formed from annular stacked laminations. The radially inner surface of the stator core 34 includes a plurality of axially extending stator slots defined between stator teeth. The conductors of a stator winding are received in the stator slots. (Note that in Figure 2 the stator winding has been omitted for clarity.)

The stator core 34 includes a plurality of axially extending voids 40 that are defined by openings in the laminations. Each void 40 extends through the stator core (optionally through a stator tooth) and defines a cooling passageway 2 through which the cooling water flows during operation of the electrical machine. The cooling water flowing through the cooling passageways 2 is therefore in direct contact with the stacked laminations of the stator core. The inlet 2a of each cooling passageway 2 is connected to the first outlet 6b of the vent tank 6 via the first manifold 36A. The outlet 2b of each cooling passageway 2 is connected to the second inlet 10b of the aspirator 10 via the second manifold 36B. The electrical machine 24 can have any suitable number of cooling passageways 2 connected in parallel between the first and second manifolds 36A, 36B. But it will be readily understood that other ways of connecting a plurality of cooling passageways are possible.

## Claims

1. Combination of:
an electrical machine (24) comprising a stator (26) and a cooling passageway (2) formed in or adjacent to the stator (26) and adapted to cool the stator (26), and
a negative relative pressure cooling system (4) connected to the cooling passageway (2) and adapted to move cooling liquid through the cooling passageway (2) at a pressure less than the ambient atmospheric pressure.

2. Combination according to claim 1, wherein the cooling passageway (2) is an axially extending cooling passageway through the stator core (34) or stator tooth of the stator (26).

3. Combination according to claim 1 or claim 2, wherein the stator (26) is a laminated stator and the cooling passageway (2) is defined by an axially extending void in the lamination stack such that the cooling liquid is in direct contact with the lamination stack.

4. Combination according to any preceding claim, wherein the cooling system (4) comprises a source of cooling liquid (6).

5. Combination according to claim 4, wherein the cooling passageway (2) comprises an inlet (2a) connected to the source of cooling liquid (6) and an outlet (2b) for discharging the cooling liquid and any entrained air that enters the cooling passageway (2).

6. Combination according to claim 5, wherein the cooling system (4) further comprises a liquid-actuated aspirator (10) including a first inlet (10a) connected to a source of motive liquid (6), a second inlet (10b) connected to the outlet (2a) of the cooling passageway (2) for receiving the cooling liquid and any entrained air, and an outlet (10c) for discharging the motive liquid, the cooling liquid and any entrained air.

7. Combination according to claim 6, wherein the source of cooling liquid is a vent tank (6) comprising a first outlet (6a) connected to the inlet (2a) of the cooling passageway (2) and an inlet (6b) connected to the outlet (10c) of the liquid-actuated aspirator (10) for receiving the motive liquid, the cooling liquid and any entrained air, and wherein the vent tank (6) is adapted to vent any entrained air.

8. Combination according to claim 7, wherein the source of motive liquid is the vent tank (6), wherein the vent tank (6) further comprises a second outlet (6c), and wherein the cooling system (4) further comprises a pump (14) connected to the second outlet (6c) of the vent tank (6) and the first inlet (10a) of the liquid-actuated aspirator (10).

9. A method of cooling an electrical machine (24) comprising a stator (26) and a cooling passageway (2) formed in or adjacent to the stator (26) and adapted to cool the stator (26), the method comprising moving cooling liquid through the cooling passageway (2) at a pressure less than the ambient atmospheric pressure.

10. A method according to claim 9, wherein the cooling passageway (2) is an axially extending cooling passageway through the stator core (34) or stator tooth of the stator (26).

11. A method according to claim 9 or claim 10, wherein the stator (26) is a laminated stator and the cooling passageway (2) is defined by an axially extending void in the lamination stack such that the cooling liquid is in direct contact with the lamination stack.

12. A method according to any of claims 9 to 11, wherein the step of moving cooling liquid through the cooling passageway (2) comprises drawing cooling liquid from a source (6) through the cooling passageway (2) and discharging from the cooling passageway (2) the cooling liquid and any entrained air that enters the cooling passageway (2).

13. A method according to claim 12, wherein the cooling liquid is drawn from the source (6) by a liquid-actuated aspirator (10).

## Patentansprüche

1. Kombination aus:
einer elektrischen Maschine (24), die einen Stator (26) und einen Kühldurchgang (2) umfasst, der in oder neben dem Stator (26) ausgebildet ist und so angepasst ist, dass er den Stator (26) kühlt, und
einem Kühlsystem (4) mit relativem Unterdruck, das mit dem Kühldurchgang (2) verbunden ist und so angepasst ist, dass es Kühlflüssigkeit bei einem Druck, der geringer ist als der atmosphärische Umgebungsdruck, durch den Kühldurchgang (2) bewegt.

2. Kombination nach Anspruch 1, wobei der Kühldurchgang (2) ein axial verlaufender Kühldurchgang durch den Statorkern (34) oder Statorzahn des Stators (26) ist.

3. Kombination nach Anspruch 1 oder Anspruch 2, wobei der Stator (26) ein laminierter Stator ist und der Kühldurchgang (2) durch einen sich axial erstreckenden Hohlraum in dem Laminierungsstapel definiert ist, so dass die Kühlflüssigkeit in direktem Kontakt mit dem Laminierungsstapel steht.

4. Kombination nach einem vorstehenden Anspruch, wobei das Kühlsystem (4) eine Quelle von Kühlflüssigkeit (6) umfasst.

5. Kombination nach Anspruch 4, wobei der Kühldurchgang (2) einen Einlass (2a), der mit der Quelle von Kühlflüssigkeit (6) verbunden ist, und einen Auslass (2b) zum Ablassen der Kühlflüssigkeit und jeglicher mitgerissener Luft, die in den Kühldurchgang (2) eintritt, umfasst.

6. Kombination nach Anspruch 5, wobei das Kühlsystem (4) weiter einen flüssigkeitsbetätigten Ansauger (10) umfasst, der einen ersten Einlass (10a), der mit einer Quelle von Antriebsflüssigkeit (6) verbunden ist, einen zweiten Einlass (10b), der mit dem Auslass (2a) des Kühldurchgangs (2) verbunden ist, um die Kühlflüssigkeit und jegliche mitgerissene Luft aufzunehmen, und einen Auslass (10c) zum Ablassen der Antriebsflüssigkeit, der Kühlflüssigkeit und jeglicher mitgerissener Luft einschließt.

7. Kombination nach Anspruch 6, wobei die Quelle von Kühlflüssigkeit ein Entlüftungstank (6) ist, der einen ersten Auslass (6a), der mit dem Einlass (2a) des Kühldurchgangs (2) verbunden ist, und einen Einlass (6b) umfasst, der mit dem Auslass (10c) des flüssigkeitsbetätigten Ansaugers (10) verbunden ist, um die Antriebsflüssigkeit, die Kühlflüssigkeit und jegliche mitgerissene Luft aufzunehmen, und wobei der Entlüftungstank (6) so angepasst ist, dass er jegliche mitgerissene Luft entlüftet.

8. Kombination nach Anspruch 7, wobei die Quelle von Antriebsflüssigkeit der Entlüftungstank (6) ist, wobei der Entlüftungstank (6) weiter einen zweiten Auslass (6c) umfasst, und wobei das Kühlsystem (4) weiter eine Pumpe (14) umfasst, die mit dem zweiten Auslass (6c) des Entlüftungstanks (6) und dem ersten Einlass (10a) des flüssigkeitsbetätigten Ansaugers (10) verbunden ist.

9. Verfahren zum Kühlen einer elektrischen Maschine (24), die einen Stator (26) und einen Kühldurchgang (2) aufweist, der in oder neben dem Stator (26) ausgebildet und so angepasst ist, dass er den Stator (26) kühlt, wobei das Verfahren das Bewegen von Kühlflüssigkeit durch den Kühldurchgang (2) bei einem Druck umfasst, der geringer ist als der atmosphärische Umgebungsdruck.

10. Verfahren nach Anspruch 9, wobei der Kühldurchgang (2) ein axial verlaufender Kühldurchgang durch den Statorkern (34) oder Statorzahn des Stators (26) ist.

11. Verfahren nach Anspruch 9 oder Anspruch 10, wobei der Stator (26) ein laminierter Stator ist und der Kühldurchgang (2) durch einen sich axial erstreckenden Hohlraum in dem Laminierungsstapel definiert ist, so dass die Kühlflüssigkeit in direktem Kontakt mit dem Laminierungsstapel steht.

12. Verfahren nach einem der Ansprüche 9 bis 11, wobei der Schritt des Bewegens von Kühlflüssigkeit durch den Kühldurchgang (2) das Ansaugen von Kühlflüssigkeit aus einer Quelle (6) durch den Kühldurchgang (2) und das Ablassen der Kühlflüssigkeit und jeglicher mitgerissener Luft, die in den Kühldurchgang (2) eintritt, aus dem Kühldurchgang (2) umfasst.

13. Verfahren nach Anspruch 12, wobei die Kühlflüssigkeit durch einen flüssigkeitsbetätigten Ansauger (10) aus der Quelle (6) angesaugt wird.

## Revendications

1. Combinaison de :
une machine électrique (24) comprenant un stator (26) et un passage de refroidissement (2) formé dans ou de manière adjacente au stator (26) et adapté pour refroidir le stator (26), et
un système de refroidissement (4) à pression relative négative relié au passage de refroidissement (2) et adapté pour déplacer un liquide de refroidissement à travers le passage de refroidissement (2) à une pression inférieure à la pression atmosphérique ambiante.

2. Combinaison selon la revendication 1, dans laquelle le passage de refroidissement (2) est un passage de refroidissement s'étendant axialement à travers le noyau de stator (34) ou la dent de stator du stator (26).

3. Combinaison selon la revendication 1 ou la revendication 2, dans laquelle le stator (26) est un stator feuilleté et le passage de refroidissement (2) est défini par un vide s'étendant axialement dans l'empilage de feuilles de tôles de manière à ce que le liquide de refroidissement soit en contact direct avec l'empilage de feuilles de tôles.

4. Combinaison selon une quelconque revendication précédente, dans laquelle le système de refroidissement (4) comprend une source de liquide de refroidissement (6).

5. Combinaison selon la revendication 4, dans laquelle le passage de refroidissement (2) comprend une entrée (2a) reliée à la source de liquide de refroidissement (6) et une sortie (2b) pour évacuer le liquide de refroidissement et tout air entraîné qui pénètre dans le passage de refroidissement (2).

6. Combinaison selon la revendication 5, dans laquelle le système de refroidissement (4) comprend en outre un aspirateur (10) actionné par un liquide incluant une première entrée (10a) reliée à une source de liquide moteur (6), une seconde entrée (10b) reliée à la sortie (2a) du passage de refroidissement (2) pour recevoir le liquide de refroidissement et tout air entraîné, et une sortie (10c) pour évacuer le liquide moteur, le liquide de refroidissement et tout air entraîné.

7. Combinaison selon la revendication 6, dans laquelle la source de liquide de refroidissement est un réservoir de mise à l'air libre (6) comprenant une première sortie (6a) reliée à l'entrée (2a) du passage de refroidissement (2) et une entrée (6b) reliée à la sortie (10c) de l'aspirateur (10) actionné par un liquide pour recevoir le liquide moteur, le liquide de refroidissement et tout air entraîné, et dans laquelle le réservoir de mise à l'air libre (6) est adapté pour évacuer tout air entraîné.

8. Combinaison selon la revendication 7, dans laquelle la source de liquide moteur est le réservoir de mise à l'air libre (6), dans laquelle le réservoir de mise à l'air libre (6) comprend en outre une seconde sortie (6c), et dans laquelle le système de refroidissement (4) comprend en outre une pompe (14) reliée à la seconde sortie (6c) du réservoir de mise à l'air libre (6) et à la première entrée (10a) de l'aspirateur (10) actionné par un liquide.

9. Procédé de refroidissement d'une machine électrique (24) comprenant un stator (26) et un passage de refroidissement (2) formé dans ou de manière adjacente au stator (26) et adapté pour refroidir le stator (26), le procédé comprenant un déplacement d'un liquide de refroidissement à travers le passage de refroidissement (2) à une pression inférieure à la pression atmosphérique ambiante.

10. Procédé selon la revendication 9, dans lequel le passage de refroidissement (2) est un passage de refroidissement s'étendant axialement à travers le noyau de stator (34) ou la dent de stator du stator (26).

11. Procédé selon la revendication 9 ou la revendication 10, dans lequel le stator (26) est un stator feuilleté et le passage de refroidissement (2) est défini par un vide s'étendant axialement dans l'empilage de feuilles de tôles de manière à ce que le liquide de refroidissement soit en contact direct avec l'empilage de feuilles de tôles.

12. Procédé selon l'une quelconque des revendications 9 à 11, dans lequel l'étape consistant à déplacer le liquide de refroidissement à travers le passage de refroidissement (2) comprend une aspiration du liquide de refroidissement à partir d'une source (6) à travers le passage de refroidissement (2) et une évacuation du liquide de refroidissement du passage de refroidissement (2) et de tout air entraîné qui pénètre dans le passage de refroidissement (2).

13. Procédé selon la revendication 12, dans lequel le liquide de refroidissement est aspiré à partir de la source (6) par un aspirateur (10) actionné par un liquide.
